# EUROPEAN PATENT SPECIFICATION

(11) **EP 3 437 120 B1**
(45) Date of publication and mention of the grant of the patent: **18.11.2020**
(21) Application number: 16897275.0
(22) Date of filing: 28.03.2016
(51) Int. Cl.: H01L 21/027, H01L 21/336

(54) **ALIGNED PITCH-QUARTERED PATTERNING FOR LITHOGRAPHY EDGE PLACEMENT ERROR ADVANCED RECTIFICATION**
AUSGERICHTETE RASTERGEVIERTELTE STRUKTURIERUNG ZUR FORTSCHRITTLICHEN KORREKTUR VON LITHOGRAPHIEKANTENPLATZIERUNGSFEHLERN
FORMATION DE MOTIFS À QUART DE PAS ALIGNÉE POUR CORRECTION AVANCÉE D'ERREUR DE PLACEMENT DE BORD DE LITHOGRAPHIE

(43) Date of publication of application: 06.02.2019
(73) Proprietor: INTEL Corporation, Santa Clara, CA 95054 (US)
(72) Inventor: WALLACE, Charles H., Portland, OR 97212 (US); CHANDHOK, Manish, Beaverton, OR 97006 (US); NYHUS, Paul A., Portland, OR 97239 (US); HAN, Eungnak, Portland, OR 97229 (US); BOJARSKI, Stephanie A., Beaverton, OR 97008 (US); GSTREIN, Florian, Portland, OR 97212 (US); SINGH, Gurpreet, Portland, OR 97229 (US)
(74) Representative: HGF
(86) International application number: PCT/US2016/024556
(87) International publication number: WO 2017/171717

(56) References cited:
- WO-A1-2015/094305
- KR-A- 20130 034 778
- US-A1- 2013 026 571
- US-A1- 2013 065 326
- US-A1- 2013 187 206
- US-A1- 2013 309 838
- US-A1- 2015 118 822
- US-A1- 2016 071 930
- LIU CHI-CHUN C ET AL: "DSA patterning options for FinFET formation at 7nm node", PROCEEDINGS OF SPIE; [PROCEEDINGS OF SPIE ISSN 0277-786X VOLUME 10524], SPIE, US, vol. 9777, 22 March 2016 (2016-03-22), pages 97770R-97770R, XP060067761, DOI: 10.1117/12.2219670 ISBN: 978-1-5106-1533-5
- JI SHENGXIANG ET AL: "Directed self-assembly of block copolymers on chemical patterns: A platform for nanofabrication", PROGRESS IN POLYMER SCIENCE, PERGAMON PRESS, OXFORD, GB, vol. 54, 28 October 2015 (2015-10-28), pages 76-127, XP029483090, ISSN: 0079-6700, DOI: 10.1016/J.PROGPOLYMSCI.2015.10.006
- GERARD SCHMID ET AL: "Fabrication of 28nm pitch Si fins with DSA lithography", PROCEEDINGS OF SPIE, vol. 8680, 26 March 2013 (2013-03-26), page 86801F, XP055629507, ISSN: 0277-786X, DOI: 10.1117/12.2011607

## Description

### TECHNICAL FIELD

Embodiments of the invention are in the field of semiconductor devices and processing and, in particular, a method of fabricating non-planar semiconductor devices.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

The document "Fabrication of 28 nm pitch Si fins with DSA lithography" from Gerard Schmid et al., Proceedings of SPIE, vol 8680, pages 86801F-1 - 86801F-12, published on 26-03-2013, discloses a known method for the fabrication of fins based on a directed self assembly lithography.

### BRIEF DESCRIPTION OF THE DRAWINGS

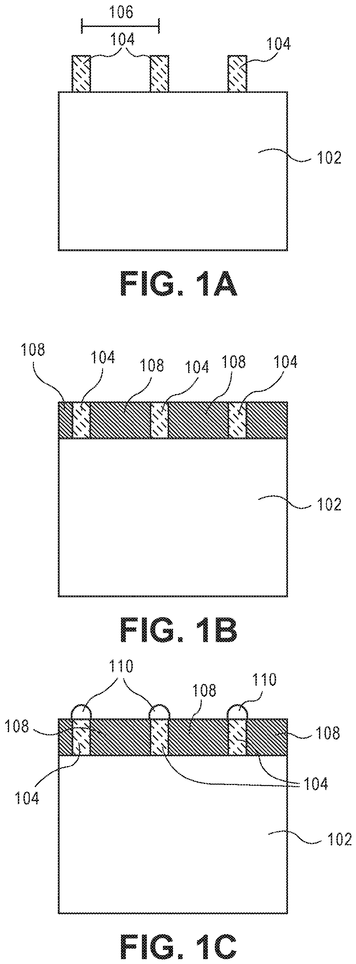

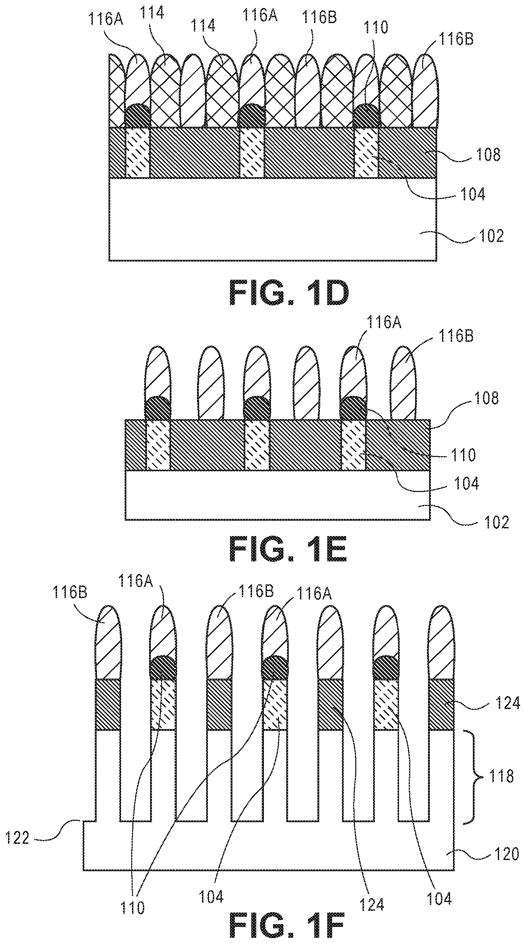

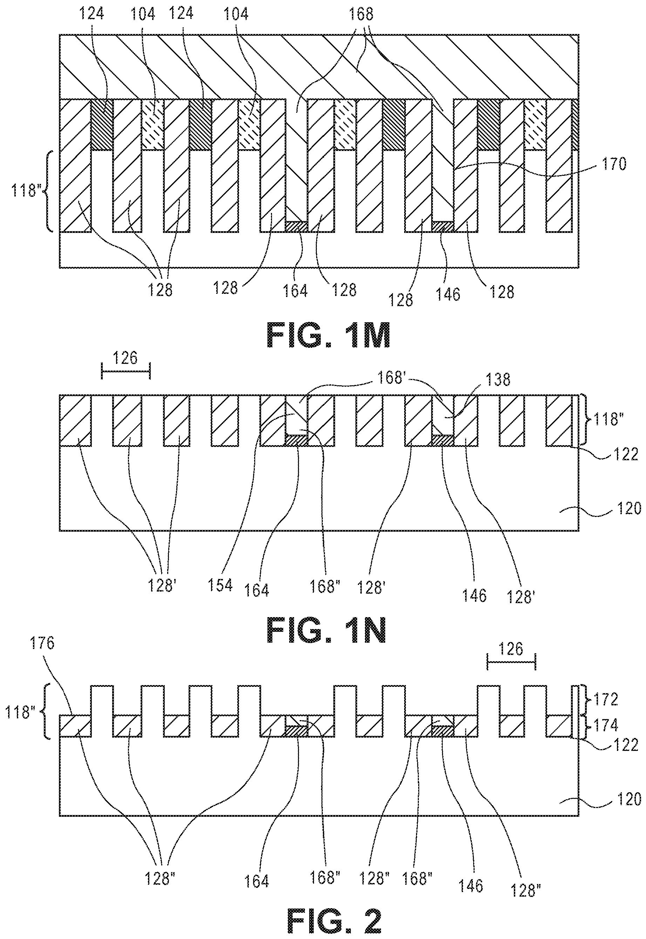

Figures 1A-1N illustrate cross-sectional view of various operations in a method of fabricating non-planar semiconductor devices, in accordance with an embodiment of the present invention, where:
Figure 1A illustrates a bulk semiconductor substrate having a first patterned hardmask formed thereon;
Figure 1B illustrates the structure of Figure 1A following formation of a second hardmask layer between the first patterned hardmask;
Figure 1C illustrates the structure of Figure 1B following application of a selective brush material layer;
Figure ID illustrates the structure of Figure 1C following application of a direct self-assembly (DSA) block co-polymer and polymer assembly process;
Figure IE illustrates the structure of Figure ID following removal of one of the blocks of the di-block co-polymer;
Figure IF illustrates the structure of Figure IE following transfer of the pattern of the remaining polymer portions into the underlying bull crystalline semiconductor substrate;
Figure 1G illustrates the structure of Figure IF following removal of the reaming polymer layer and any brush layers;
Figure 1H illustrates the structure of Figure 1G following formation of an inter-layer dielectric (ILD) layer between the plurality of fins;
Figure 1I illustrates the structure of Figure 1H following formation and patterning of a photoresist material to form a patterned mask;
Figure 1J illustrates the structure of Figure 1I following etching of the select one of the plurality of fins;
Figure 1K illustrates the structure of Figure 1J following formation and patterning of a photoresist material to form a patterned mask;
Figure 1L illustrates the structure of Figure 1K following etching of the select second of the plurality of fins;
Figure 1M illustrates the structure of Figure 1L following removal of the patterned mask and formation of an inter-layer dielectric (ILD) layer over the plurality of fins and in locations and of removed fins; and
Figure IN illustrates the structure of Figure 1M following planarization of ILD layer and removal of first and second patterned hardmasks.
Figure 2 illustrates the structure of Figure IN following exposing of upper portions of the plurality of fins.
Figure 3A illustrates a cross-sectional view of a non-planar semiconductor device.
Figure 3B illustrates a plan view taken along the a-a' axis of the semiconductor device of Figure 3A.
Figure 4 illustrates a computing device.
Figure 5 illustrates an interposer.

### DESCRIPTION OF THE EMBODIMENTS

Aligned pitch-quartered patterning approaches for lithography edge placement error advanced rectification are described. In the following description, numerous specific details are set forth, such as specific integration and material regimes, in order to provide a thorough understanding of embodiments of the present invention. It will be apparent to one skilled in the art that embodiments of the present invention may be practiced without these specific details. In other instances, well-known features, such as integrated circuit design layouts, are not described in detail in order to not unnecessarily obscure embodiments of the present invention. Furthermore, it is to be understood that the various embodiments shown in the Figures are illustrative representations and are not necessarily drawn to scale.

One or more embodiments described herein is directed to processes and structures based on and resulting from aligned pitch-quartered patterning approaches for edge placement error (EPE) rectification. One or more embodiments may be described as a differentiated or "colored" alternating hardmask approach for semiconductor fin patterning. Embodiments may include one or more of directed self-assembly (DSA), semiconductor material patterning, pitch division such as pitch quartering, differentiated hardmask selectivity, self-alignment for fin patterning. One or more embodiments is particularly suited for non-planar semiconductor device fabrication.

In accordance with an embodiment of the present invention, doubling of allowed edge placement error and doubling of the cut size for cutting of small features at tight pitch is implemented for very fine fin patterning. In one embodiment, all features (e.g., fin lines) are transferred into a semiconductor substrate with a single population of critical dimension (CD) variation. This approach is in contrast to state of the art approaches that rely on spacer-based pitch quartering which typically has three discreet populations of line widths (e.g., backbone, complement and spacer dimensions).

To provide context, it may be desirable to use bulk silicon for fins or trigate based semiconductor devices. In an embodiment, directed self-assembly (DSA) is implemented to accomplish pitch division and "coloring" of every other feature in a desired pattern. In one such embodiment, the patterning approach is particularly applicable to patterning silicon fins in a tri-gate transition patterning flow. In an embodiment advantages of implementing approaches described herein may include one or more of: (1) enabling a single population of feature widths, (2) doubling the edge placement error requirements for feature cutting, (3) doubling dimensions of the hole or opening required to cut a single feature (e.g., relaxing the restrictions on the size of the opening), or (4) reducing the cost of the patterning process. Structural artifacts resulting from the process include, in an embodiment, a single population of critical dimensions and at the transitions from one pitch to another and/or from one grid to another at the guard rings surrounding the die of the chips. Embodiments may enable cutting of tight pitch lines without scaling the edge-placement error requirements.

In an exemplary processing scheme, Figures 1A-1N illustrate cross-sectional view of various operations in a method of fabricating non-planar semiconductor devices, in accordance with an embodiment of the present invention.

Figure 1A illustrates a bulk semiconductor substrate 102 having a first patterned hardmask 104 formed thereon. In an embodiment, the bulk semiconductor substrate 102 is a bulk single crystalline silicon substrate is provided having fins 102 etched therein. In one embodiment, the bulk semiconductor substrate 102 is undoped or lightly doped at this stage. For example, in a particular embodiment, the bulk semiconductor substrate 102 has a concentration of less than approximately 1E17 atoms/cm³ of boron dopant impurity atoms.

In an embodiment, the first patterned hardmask 104 includes features having a pitch 106. In one such embodiment, the first patterned hardmask 104 represents half of the possibly number of fins ultimately formed in the substrate 102. That is, the pitch 106 is effectively relaxed to double the pitch of the final pattern of fins formed. In one embodiment, the first hardmask 104 is patterned directly using a lithographic process. However, in other embodiments, pitch division is applied, e.g., pitch halving, and is used to provide patterned hardmask 104 with pitch 106. It is to be appreciated that, in an embodiment, the first guide pattern can be formed using conventional patterning (litho/etch), only litho, spacer-based double patterning or other pitch division methods. In one embodiment, the guide pattern is separated from the DSA pattern through the use of two or more hardmasks such that the CDs are formed from a single population (e.g., one etch)).

Figure 1B illustrates the structure of Figure 1A following formation of a second hardmask layer 108 between the first patterned hardmask 104. In an embodiment, the second hardmask layer 108 is formed by forming a blanket hardmask layer over the substrate 102 and first patterned hardmask 104 and then planarizing the blanket hardmask layer to form second hardmask layer 108, e.g., by chemical mechanical planarization (CMP). In other embodiment, ALD or CVD techniques will follow the contour of the surface of the wafer and since fin cuts are used as an example, the wafer is "perfectly" flat at this point in the process.

In an embodiment, the second hardmask layer 108 has an etch characteristic different from an etch characteristic of the first patterned hardmask 104.
In one embodiment, one or both of the second hardmask layer 108 or the first patterned hardmask 104 is a layer of a nitride of silicon (e.g., silicon nitride) or a layer of an oxide of silicon, or both, or a combination thereof. Other suitable materials may include carbon-based materials, such as silicon carbide. In another embodiment, a hardmask material includes a metal species. For example, a hardmask or other overlying material may include a layer of a nitride of titanium (e.g., titanium nitride) or another metal. Potentially lesser amounts of other materials, such as oxygen, may be included in one or more of these layers. The hardmask layers maybe formed by CVD, PVD, or by other deposition methods.

Figure 1C illustrates the structure of Figure 1B following application of a selective brush material layer 110. In an embodiment, the selective brush material layer 110 adheres to only the first patterned hardmask 104, as is depicted in Figure 1C. In another embodiment, however, the selective brush material is applied to the second hardmask layer 108 instead. In yet another embodiment, the selective brush material layer 110 adheres to only the first patterned hardmask 104 and a second different selective brush material is formed on the second hardmask layer 108.

In an embodiment, the selective brush material layer 110 includes a molecular species including polystyrene with a head group selected from the group consisting of-SH, - PO₃H₂, -CO₂H, -NRH, -NRR', and -Si(OR)₃. In another embodiment, selective brush material layer 110 includes a molecular species including polymethacrylate with a head group selected from the group consisting of-SH, -PO₃H₂, -CO₂H, -NRH, -NRR', and -Si(OR)₃. In an embodiment, the selective brush material layer 110 is attracted to one constituent of a DSA block co-polymer (e.g., polystrene or polymethylmethacrylate).

Figure ID illustrates the structure of Figure 1C following application of a direct self-assembly (DSA) block co-polymer 114/116(A/B) and polymer assembly process. In an embodiment, a DSA block co-polymer is coated on the surface and annealed to segregate the polymer into first blocks 114 and second blocks 116 (identified as 116A and 116B in Figure ID). In one embodiment, polymer block 116 preferentially attaches to the selective brush material layer 110 during the anneal process. The second polymer block 114 adheres to the second hardmask layer 108. In a particular embodiment, however, the pitch of the assembly is half the pitch of the first patterned hardmask 104. In this case, portions 116A of the first block are adhered to the selective brush material layer 110 of the first hardmask 104, while second portions 116B of the first block are formed on the second hardmask layer 108, between second block portions 114.

In an embodiment, the block copolymer molecule 114/116(A/B) is a polymeric molecule formed of a chain of covalently bonded monomers. In a di-block copolymer, there are two different types of monomers, and these different types of monomers are primarily included within two different blocks or contiguous sequences of monomers. The illustrated block copolymer molecule includes a block of polymer 114 and a block of polymer 116(A/B). In an embodiment, the block of polymer 114 includes predominantly a chain of covalently linked monomer A (e.g., A-A-A-A-A...), whereas the block of polymer 116(A/B) includes predominantly a chain of covalently linked monomer B (e.g., B-B-B-B-B...). The monomers A and B may represent any of the different types of monomers used in block copolymers known in the arts. By way of example, the monomer A may represent monomers to form polystyrene, and the monomer B may represent monomers to form poly(methyl methacrylate) (PMMA), or vice versa, although the scope of the invention is not so limited. In other embodiments, there may be more than two blocks. Moreover, in other embodiments, each of the blocks may include different types of monomers (e.g., each block may itself be a copolymer). In one embodiment, the block of polymer 114 and the block of polymer 116(A/B) are covalently bonded together. The block of polymer 114 and the block of polymer 116(A/B) may be of approximately equal length, or one block may be significantly longer than the other.

Typically, the blocks of block copolymers (e.g., the block of polymer 114 and the block of polymer 116(A/B)) may each have different chemical properties. As one example, one of the blocks may be relatively more hydrophobic (e.g., water repelling) and the other may be relatively more hydrophilic (water attracting). At least conceptually, one of the blocks may be relatively more similar to oil and the other block may be relatively more similar to water. Such differences in chemical properties between the different blocks of polymers, whether a hydrophilic-hydrophobic difference or otherwise, may cause the block copolymer molecules to self-assemble. For example, the self-assembly may be based on microphase separation of the polymer blocks. Conceptually, this may be similar to the phase separation of oil and water which are generally immiscible. Similarly, differences in hydrophilicity between the polymer blocks (e.g., one block is relatively hydrophobic and the other block is relatively hydrophilic), may cause a roughly analogous microphase separation where the different polymer blocks try to "separate" from each other due to chemical dislike for the other.

However, in an embodiment, since the polymer blocks are covalently bonded to one another, they cannot completely separate on a macroscopic scale. Rather, polymer blocks of a given type may tend to segregate or conglomerate with polymer blocks of the same type of other molecules in extremely small (e.g., nano-sized) regions or phases. The particular size and shape of the regions or microphases generally depends at least in part upon the relative lengths of the polymer blocks. In an embodiment, by way of example, in two block copolymers, if the blocks are approximately the same length, a grid like pattern of alternating polymer 114 lines and polymer 116(A/B) lines is generated.

In an embodiment, the polymer 114/polymer 116(A/B) grating is first applied as an unassembled block copolymer layer portion that includes a block copolymer material applied, e.g., by brush or other coating process. The unassembled aspect refers to scenarios where, at the time of deposition, the block copolymer has not yet substantially phase separated and/or self-assembled to form nanostructures. In this unassembled form, the block polymer molecules are relatively highly randomized, with the different polymer blocks relatively highly randomly oriented and located. The unassembled block copolymer layer portion may be applied in a variety of different ways. By way of example, the block copolymer may be dissolved in a solvent and then spin coated over the surface. Alternatively, the unassembled block copolymer may be spray coated, dip coated, immersion coated, or otherwise coated or applied over the surface. Other ways of applying block copolymers, as well as other ways known in the arts for applying similar organic coatings, may potentially be used. Then, the unassembled layer may form an assembled block copolymer layer portion, e.g., by microphase separation and/or self-assembly of the unassembled block copolymer layer portion. The microphase separation and/or self-assembly occurs through rearrangement and/or repositioning of the block copolymer molecules, and in particular to rearrangement and/or repositioning of the different polymer blocks of the block copolymer molecules.

In one such embodiment, an annealing treatment may be applied to the unassembled block copolymer in order to initiate, accelerate, increase the quality of, or otherwise promote microphase separation and/or self-assembly. In some embodiments, the annealing treatment may include a treatment that is operable to increase a temperature of the block copolymer. One example of such a treatment is baking the layer, heating the layer in an oven or under a thermal lamp, applying infrared radiation to the layer, or otherwise applying heat to or increasing the temperature of the layer. The desired temperature increase will generally be sufficient to significantly accelerate the rate of microphase separation and/or self-assembly of the block polymer without damaging the block copolymer or any other important materials or structures of the integrated circuit substrate. Commonly, the heating may range between about 50°C to about 300°C, or between about 75°C to about 250°C, but not exceeding thermal degradation limits of the block copolymer or integrated circuit substrate. The heating or annealing may help to provide energy to the block copolymer molecules to make them more mobile/flexible in order to increase the rate of the microphase separation and/or improve the quality of the microphase separation. Such microphase separation or rearrangement/repositioning of the block copolymer molecules may lead to self-assembly to form extremely small (e.g., nano-scale) structures. The self-assembly may occur under the influence of surface energy, molecular affinities, and other surface-related and chemical-related forces.

In any case, in some embodiments, self-assembly of block copolymers, whether based on hydrophobic-hydrophilic differences or otherwise, may be used to form extremely small periodic structures (e.g., precisely spaced nano-scale structures or lines). In some embodiments, they may be used to form nano-scale lines or other nano-scale structures that can ultimately be used to form semiconductor fin lines.

Figure IE illustrates the structure of Figure ID following removal of one of the blocks of the di-block co-polymer. In an embodiment, the polymer portions 114 are removed selectively through a wet or dry etch process to leave portions 116(A/B). The pitch of the remaining portions 116(A/B) is approximately half the pitch of the first patterned hardmask 104.

Figure IF illustrates the structure of Figure IE following transfer of the pattern of the remaining polymer portions into the underlying bull crystalline semiconductor substrate. In an embodiment, the pattern of the remaining polymer portion 116(A/B), i.e., the pattern of first patterned hardmask 104 as pitch halved, is etched into the bulk semiconductor substrate 102. The patterning patterns second hardmask layer 108 to form second patterned hardmask layer 124 corresponding to polymer portions 116B. First patterned hardmask 104 corresponds to polymer portions 116A. In an embodiment, a plurality of fins 118 is formed directly in the bulk substrate 102 which becomes patterned substrate 120 and, as such, are formed continuous with the bulk substrate 102/120 at an approximately planar surface 122.

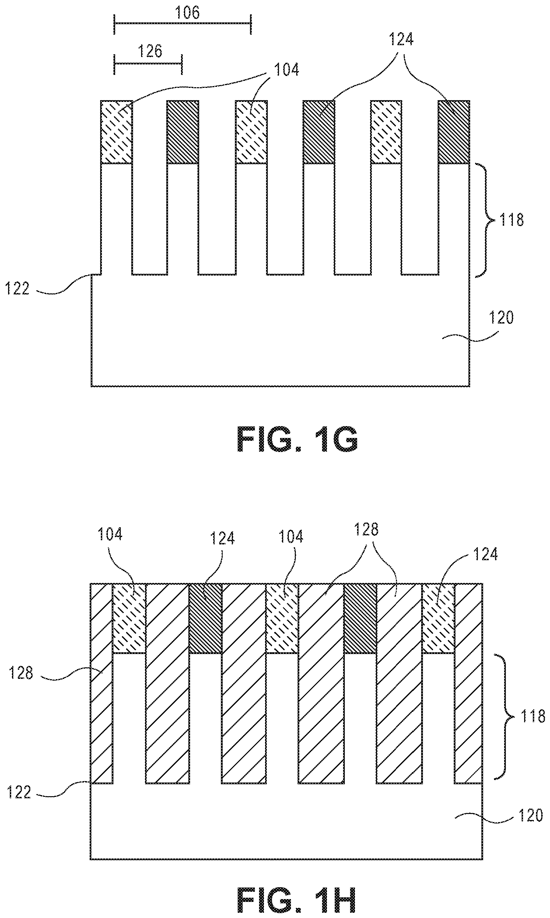

Figure 1G illustrates the structure of Figure IF following removal of the remaining polymer layer and any brush layers. In an embodiment, the remaining polymer layer 116(A/B) and the brush layer 110 are removed to leave the plurality of alternating fins 118 having alternating "colored" first patterned hardmask 104 and second patterned hardmask 124 thereon. In one embodiment, the remaining polymer layer 116(A/B) and the brush layer 110 are removed using an ashing and cleans process. The resulting pitch 126 of the fins is half of the pitch 106 of the original first patterned hardmask 104.

Figure 1H illustrates the structure of Figure 1G following formation of an inter-layer dielectric (ILD) layer 128 between the plurality of fins 118. In an embodiment, the ILD layer 128 is composed of silicon dioxide, such as is used in a shallow trench isolation fabrication process. However, other dielectrics may be used instead, such as nitrides of carbides. The ILD layer 128 may be deposited by a chemical vapor deposition (CVD) or other deposition process (e.g., ALD, PECVD, PVD, HDP assisted CVD, low temp CVD) and may be planarized by a chemical mechanical polishing (CMP) technique to reveal uppermost surfaces of hardmask layers 104 and 128.

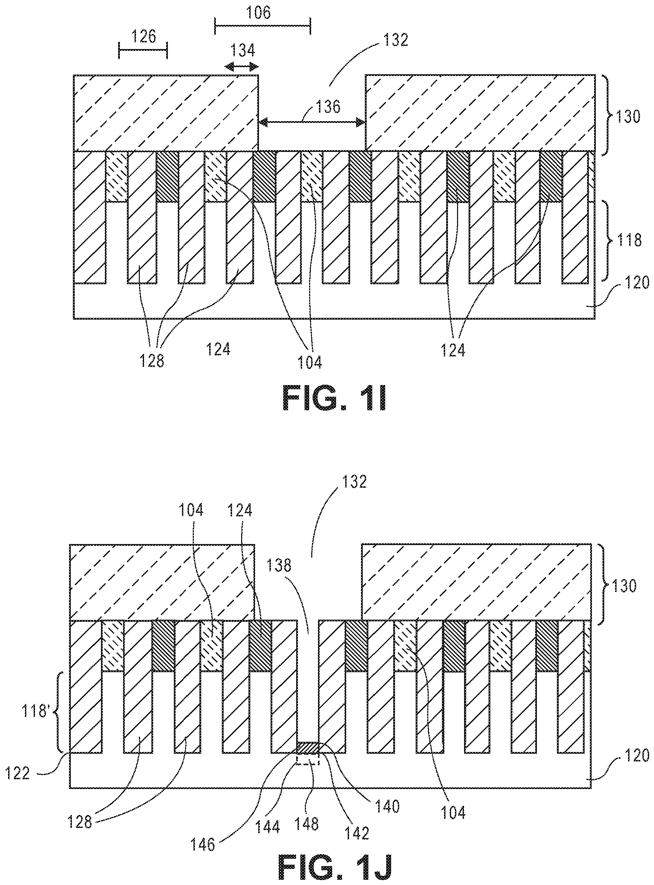

Figure 1I illustrates the structure of Figure 1H following formation and patterning of a photoresist material to form a patterned mask 130. In an embodiment, patterned mask 130 has an opening 132 formed therein. The opening 132 exposes a target one of the plurality of fins 118 having first patterned hardmask 104 thereon for ultimate fin removal. The opening 132 has a cut dimension 136. In an embodiment, restraints on the cut dimension 136 are relaxed, and may even expose portions of neighboring fins having second patterned hardmask 124 thereon. In an embodiment, the patterning operation prepares for cutting away of unwanted features using "coloring" or hardmask material differentiation to allow for cut sizes to be twice the pitch 126 of the features 118 (i.e., to result in the original pitch 106). In one embodiment, the hardmask material allows differentiation through plasma or wet etch selectivity between the two hardmask materials. Furthermore, the edge placement error (EPE) 134 is half pitch. By comparison, in a standard patterning process, without coloring, the cut dimension is IX pitch and the edge-placement error (EPE) is ¼ pitch. Thus, in an embodiment, the process described herein doubles the edge placement error budget and doubles the size of the holes or openings required to cut a single feature.

In an embodiment, patterned mask 130 is composed of a photoresist layer, as is known in the art, and may be patterned by conventional lithography and development processes. In a particular embodiment, the portions of the photoresist layer exposed to the light source are removed upon developing the photoresist layer. Thus, patterned photoresist layer is composed of a positive photoresist material. In a specific embodiment, the photoresist layer is composed of a positive photoresist material such as, but not limited to, a 248nm resist, a 193nm resist, a 157nm resist, an extreme ultra violet (EUV) resist, an e-beam resist, an imprint layer, or a phenolic resin matrix with a diazonaphthoquinone sensitizer. In another particular embodiment, the portions of the photoresist layer exposed to the light source are retained upon developing the photoresist layer. Thus, the photoresist layer is composed of a negative photoresist material. In a specific embodiment, the photoresist layer is composed of a negative photoresist material such as, but not limited to, consisting of poly-cis-isoprene or poly-vinyl-cinnamate. In an embodiment, lithographic operations are performed using 193nm immersion litho (193i), EUV and/or EBDW lithography, or the like. A positive tone or a negative tone resist may be used. In one embodiment, the patterned mask 130 is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon-containing ARC layer. In one such embodiment, a spin-on glass material with added chromophores is used to aid in suppressing reflectivity. Chemically they are (siloxanes) silicon-carbon containing polymers. When annealed they form a mixture of silicon dioxide and carbon polymers.

Figure 1J illustrates the structure of Figure 1I following etching of the select one of the plurality of fins 118 and subsequent removal of patterned mask 130. In one embodiment, this process is referred to as a "fin cut", or " feature selection" operation of the process. In an embodiment, one of the plurality of fins 118 is removed at location 138 to form patterned plurality of fins 118' having a first interrupted pattern. In one such embodiment, the exposed first patterned hardmask 104 is first removed using an etch process selective to any exposed second patterned hardmask 124 and selective to ILD layer 128. In another embodiment, a "fin keep" approach is used, where the features are selected using the opposite tone of photoresist and protected during the etch process while the background or unprotected fins are removed. It is the reverse polarity of the lithographic process (e.g., negative vs. positive tone imaging). It is to be appreciated that either process can be used at this operation. The exposed fin is then removed at location 138 with an etch process selective to exposed second patterned hardmask 124 and selective to ILD layer 128. In a first embodiment, the fin is removed at location 138 to a level 140 leaving a protruding portion 146 above planar surface 122. In a second embodiment, the fin is removed at location 138 to a level 142 approximately co-planar with planar surface 122. In a third embodiment, the fin is removed at location 138 to a level 144 leaving a recess 148 below planar surface 122.

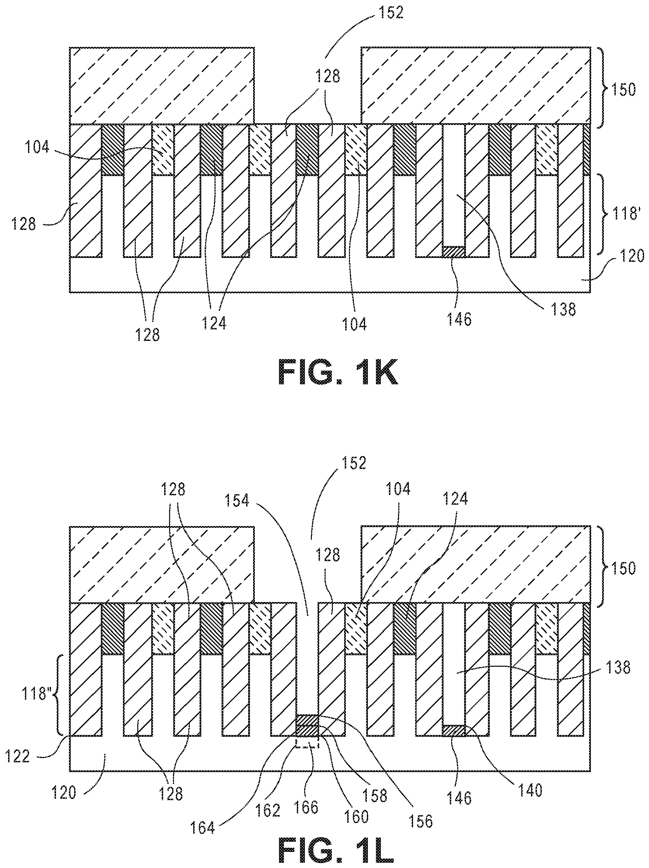

Figure 1K illustrates the structure of Figure 1J following formation and patterning of a photoresist material to form a patterned mask 150. In an embodiment, patterned mask 150 has an opening 152 formed therein. The opening 152 exposes a target second of the plurality of fins 118' having second patterned hardmask 124 thereon for ultimate fin removal. In an embodiment, the patterning operation prepares for cutting away of unwanted features using "coloring" or hardmask material differentiation to allow for cut sizes to be twice the pitch 126 of the features 118'. As described in association with Figure 1I, the process described herein doubles the edge placement error budget and doubles the size of the holes or openings required to cut a single feature. In an embodiment, patterned mask 150 is composed of a material such as described in association with Figure 1I.

Figure 1L illustrates the structure of Figure 1K following etching of the select second of the plurality of fins 118'. In an embodiment, the second of the plurality of fins 118' is removed at location 154 to form patterned plurality of fins 118" having a second interrupted pattern. In one such embodiment, the exposed second patterned hardmask 124 is first removed using an etch process selective to any exposed first patterned hardmask 104 and selective to ILD layer 128. The exposed fin is then removed at location 154 with an etch process selective to exposed first patterned hardmask 104 and selective to ILD layer 128. In a first embodiment, the fin is removed at location 154 to a level 156 leaving a protruding portion above planar surface 122 at a height above surface 140 of protruding portion 146. In a second embodiment, the fin is removed at location 154 to a level 158 leaving a protruding portion 164 above planar surface 122 and at approximately the same height as surface 140 of protruding portion 146. In a third embodiment, the fin is removed at location 154 to a level 160 approximately co-planar with planar surface 122. In a fourth embodiment, the fin is removed at location 154 to a level 162 leaving a recess 166 below planar surface 122.

Figure 1M illustrates the structure of Figure 1L following removal of the patterned mask 150 and formation of an inter-layer dielectric (ILD) layer 168 over the plurality of fins 118" and in locations 138 and 154 of removed fins. In an embodiment, the ILD layer 168 is composed of silicon dioxide, such as is used in a shallow trench isolation fabrication process. However, other dielectrics may be used instead, such as nitrides or carbides. The ILD layer 168 may be deposited by a chemical vapor deposition (CVD) or other deposition process (e.g., ALD, PECVD, PVD, HDP assisted CVD, low temp CVD). Spin-on materials are another common option for these films. Many low-k dielectric materials can be spun-on the wafer and cured. These are commonly used in the industry.

Figure IN illustrates the structure of Figure 1M following planarization of ILD layer 168 and removal of first and second patterned hardmasks 104 and 124. In an embodiment, a chemical mechanical polishing (CMP) technique is used to remove the first patterned hardmask 104 and the second hardmask 124, to recess the ILD layers 128 and 168 to formed planarized ILD layer 128' and 168', respectively, and to expose surfaces of the plurality of fins 118". In an embodiment, the planarized ILD layer 128' is composed of substantially the same material as planarized ILD layer 168'. In another embodiment, the planarized ILD layer 128' is composed of a different material than planarized ILD layer 168'. In either case, in an embodiment, a seam is formed between ILD layer 168' and ILD layer 128', e.g., at location 138 or 154. It is to be appreciated that, in an embodiment, the exposed surface of the plurality of fins 118" can be used to form planar semiconductor devices.

However, in accordance with another embodiment, Figure 2 illustrates the structure of Figure IN following exposing of upper portions of the plurality of fins 118". Referring to Figure 2, the ILD layer 168' and the ILD layer 128' are recessed to expose protruding portions 172 of fins 118' and to provide recessed ILD layer 168" and recessed ILD layer 128" to a recess height 176. The recess height 176 defines a location between upper fin portions 172 and lower fin portions 174. The recessing of the ILD layer 168' and the ILD layer 128' may be performed by a plasma, vapor or wet etch process. In one embodiment, a dry etch process selective to silicon fins 118" is used, the dry etch process based on a plasma generated from gases such as, but not limited to NF₃, CHF₃, C₄F₈, HBr and O₂ with typically pressures in the range of 30-100 mTorr and a plasma bias of 50-1000 Watts.

In an exemplary embodiment, referring again to Figures 1J, 1L and 2, a semiconductor structure includes a plurality of semiconductor fins 118" protruding from a substantially planar surface 122 of a semiconductor substrate 120. The plurality of semiconductor fins 118" has a grating pattern interrupted by a first location 138 having a first fin portion 146 having a first height. The grating pattern of the semiconductor fins is further interrupted by a second location 154 having a second fin portion 164 having a second height. In one embodiment, the second height of the second fin portion 154 is different from the first height of the first fin portion 146. In another embodiment, the second height of the second fin portion 154 is the same as the first height of the first fin portion 146. In an embodiment, the grating pattern has a constant pitch 126 when viewed without the interruptions.

In an exemplary embodiment, referring again to Figures 1J, 1L, and 2, a semiconductor structure includes a plurality of semiconductor fins 118" protruding from a substantially planar surface 122 of a semiconductor substrate 120. The plurality of semiconductor fins 118" has a grating pattern interrupted by a first location 138 having a first recess. In one embodiment, the grating pattern of the semiconductor fins is further interrupted by a second location 154 having one of a second recess, or a fin portion. In an embodiment, the grating pattern has a constant pitch 126 when viewed without the interruptions. In an embodiment, a trench isolation layer 168" is disposed in and over the recess.

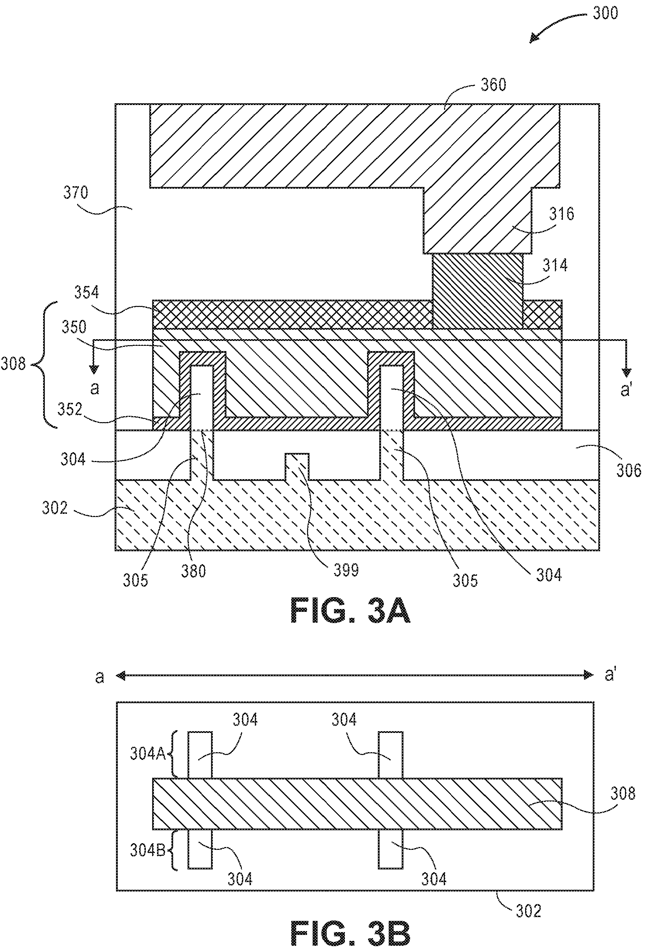

It is to be appreciated that the structures resulting from the above exemplary processing schemes, e.g., structures from Figures IN and 2, may be used in a same or similar form for subsequent processing operations to complete device fabrication, such as PMOS and NMOS device fabrication. As an example of a completed device, Figures 3A and 3B illustrate a cross-sectional view and a plan view (taken along the a-a' axis of the cross-sectional view), respectively, of a non-planar semiconductor device.

Referring to Figure 3A, a semiconductor structure or device 300 includes a non-planar active region (e.g., a fin structure including protruding fin portion 304 and sub-fin region 305) formed from substrate 302, and within isolation region 306. A gate line 308 is disposed over the protruding portions 304 of the non-planar active region as well as over a portion of the isolation region 306. As shown, gate line 308 includes a gate electrode 350 and a gate dielectric layer 352. In one embodiment, gate line 308 may also include a dielectric cap layer 354. A gate contact 314, and overlying gate contact via 316 are also seen from this perspective, along with an overlying metal interconnect 360, all of which are disposed in inter-layer dielectric stacks or layers 370. Also seen from the perspective of Figure 3A, the gate contact 314 is, in one embodiment, disposed over isolation region 306, but not over the non-planar active regions.

As is also depicted in Figure 3A, in an embodiment, an artifact of fin select recessing remains in the final structure. For example, in the embodiment shown, a residual protruding portion 399 remains. In other embodiments, a recess may remain, as described above.

As is also depicted in Figure 3A, in an embodiment, an interface 380 exists between a protruding fin portion 304 and sub-fin region 305. The interface 380 can be a transition region between a doped sub-fin region 305 and a lightly or undoped upper fin portion 304. In one such embodiment, each fin is approximately 10 nanometers wide or less, and sub-fin dopants are supplied from an adjacent solid state doping layer at the sub-fin location.

Referring to Figure 3B, the gate line 308 is shown as disposed over the protruding fin portions 304. Source and drain regions 304A and 304B of the protruding fin portions 304 can be seen from this perspective. In one embodiment, the source and drain regions 304A and 304B are doped portions of original material of the protruding fin portions 304. In another embodiment, the material of the protruding fin portions 304 is removed and replaced with another semiconductor material, e.g., by epitaxial deposition. In either case, the source and drain regions 304A and 304B may extend below the height of dielectric layer 306, i.e., into the sub-fin region 305. In accordance with an embodiment of the present invention, the more heavily doped sub-fin regions, i.e., the doped portions of the fins below interface 380, inhibits source to drain leakage through this portion of the bulk semiconductor fins.

In an embodiment, the semiconductor structure or device 300 is a non-planar device such as, but not limited to, a fin-FET or a tri-gate device. In such an embodiment, a corresponding semiconducting channel region is composed of or is formed in a three-dimensional body. In one such embodiment, the gate electrode stacks of gate lines 308 surround at least a top surface and a pair of sidewalls of the three-dimensional body.

Substrate 302 may be composed of a semiconductor material that can withstand a manufacturing process and in which charge can migrate. In an embodiment, substrate 302 is a bulk substrate composed of a crystalline silicon, silicon/germanium or germanium layer doped with a charge carrier, such as but not limited to phosphorus, arsenic, boron or a combination thereof, to form active region 304. In one embodiment, the concentration of silicon atoms in bulk substrate 302 is greater than 97%. In another embodiment, bulk substrate 302 is composed of an epitaxial layer grown atop a distinct crystalline substrate, e.g. a silicon epitaxial layer grown atop a boron-doped bulk silicon mono-crystalline substrate. Bulk substrate 302 may alternatively be composed of a group III-V material. In an embodiment, bulk substrate 302 is composed of a III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, bulk substrate 302 is composed of a III-V material and the charge-carrier dopant impurity atoms are ones such as, but not limited to, carbon, silicon, germanium, oxygen, sulfur, selenium or tellurium.

Isolation region 306 may be composed of a material suitable to ultimately electrically isolate, or contribute to the isolation of, portions of a permanent gate structure from an underlying bulk substrate or isolate active regions formed within an underlying bulk substrate, such as isolating fin active regions. For example, in one embodiment, the isolation region 306 is composed of a dielectric material such as, but not limited to, silicon dioxide, silicon oxy-nitride, silicon nitride, or carbon-doped silicon nitride.

Gate line 308 may be composed of a gate electrode stack which includes a gate dielectric layer 352 and a gate electrode layer 350. In an embodiment, the gate electrode of the gate electrode stack is composed of a metal gate and the gate dielectric layer is composed of a high-K material. For example, in one embodiment, the gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer may include a layer of native oxide formed from the top few layers of the substrate 302. In an embodiment, the gate dielectric layer is composed of a top high-k portion and a lower portion composed of an oxide of a semiconductor material. In one embodiment, the gate dielectric layer is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, the gate electrode is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode is composed of a non-workfunction-setting fill material formed above a metal workfunction-setting layer. The gate electrode layer may consist of a P-type workfunction metal or an N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

Spacers associated with the gate electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

Gate contact 314 and overlying gate contact via 316 may be composed of a conductive material. In an embodiment, one or more of the contacts or vias are composed of a metal species. The metal species may be a pure metal, such as tungsten, nickel, or cobalt, or may be an alloy such as a metal-metal alloy or a metal-semiconductor alloy (e.g., such as a silicide material).

In an embodiment (although not shown), providing structure 300 involves formation of a contact pattern which is essentially perfectly aligned to an existing gate pattern while eliminating the use of a lithographic operation with exceedingly tight registration budget. In one such embodiment, this approach enables the use of intrinsically highly selective wet etching (e.g., versus conventionally implemented dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in conventional approaches. In an embodiment, a trench contact grid is not separately patterned, but is rather formed between poly (gate) lines. For example, in one such embodiment, a trench contact grid is formed subsequent to gate grating patterning but prior to gate grating cuts.

Furthermore, the gate stack structure 308 may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of poly crystalline silicon or amorphous silicon and are removed with a dry etch process including use of SF₆. In another embodiment, dummy gates are composed of poly crystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process to arrive at structure 300. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

Referring again to Figure 3A, the arrangement of semiconductor structure or device 300 places the gate contact over isolation regions. Such an arrangement may be viewed as inefficient use of layout space. In another embodiment, however, a semiconductor device has contact structures that contact portions of a gate electrode formed over an active region. In general, prior to (e.g., in addition to) forming a gate contact structure (such as a via) over an active portion of a gate and in a same layer as a trench contact via, one or more embodiments of the present invention include first using a gate aligned trench contact process. Such a process may be implemented to form trench contact structures for semiconductor structure fabrication, e.g., for integrated circuit fabrication. In an embodiment, a trench contact pattern is formed as aligned to an existing gate pattern. By contrast, conventional approaches typically involve an additional lithography process with tight registration of a lithographic contact pattern to an existing gate pattern in combination with selective contact etches. For example, a conventional process may include patterning of a poly (gate) grid with separate patterning of contact features.

It is to be appreciated that not all aspects of the processes described above need be practiced to fall within the scope of the present invention, which is defined by the appended claims. For example, in one embodiment, dummy gates need not ever be formed prior to fabricating gate contacts over active portions of the gate stacks. The gate stacks described above may actually be permanent gate stacks as initially formed. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a trigate device, an independently accessed double gate device, or a FIN-FET. One or more embodiments may be particularly useful for fabricating semiconductor devices at a 10 nanometer (10 nm) or smaller technology node.

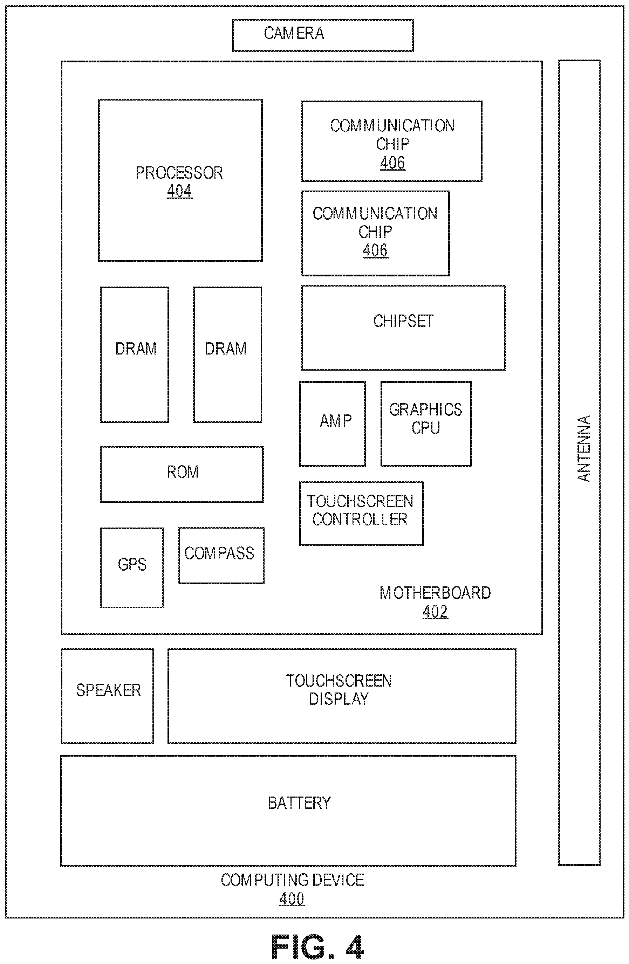

Figure 4 illustrates a computing device 400. The computing device 400 houses a board 402. The board 402 may include a number of components, including but not limited to a processor 404 and at least one communication chip 406. The processor 404 is physically and electrically coupled to the board 402. In some implementations the at least one communication chip 406 is also physically and electrically coupled to the board 402. In further implementations, the communication chip 406 is part of the processor 404.

Depending on its applications, computing device 400 may include other components that may or may not be physically and electrically coupled to the board 402. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 406 enables wireless communications for the transfer of data to and from the computing device 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 406 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 400 may include a plurality of communication chips 406. For instance, a first communication chip 406 may be dedicated to shorter range wireless communications such as Wi-Fi and Bluetooth and a second communication chip 406 may be dedicated to longer range wireless communications such as GPS, EDGE, GPRS, CDMA, WiMAX, LTE, Ev-DO, and others.

The processor 404 of the computing device 400 includes an integrated circuit die packaged within the processor 404. In some implementations of embodiments of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 406 also includes an integrated circuit die packaged within the communication chip 406. In accordance with another implementation of the invention, the integrated circuit die of the communication chip includes one or more devices, such as MOS-FET transistors built in accordance with implementations of the invention.

In further implementations, another component housed within the computing device 400 may contain an integrated circuit die that includes one or more devices, such as MOS-FET transistors built in accordance with implementations of embodiments of the invention.

In various embodiments, the computing device 400 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 400 may be any other electronic device that processes data.

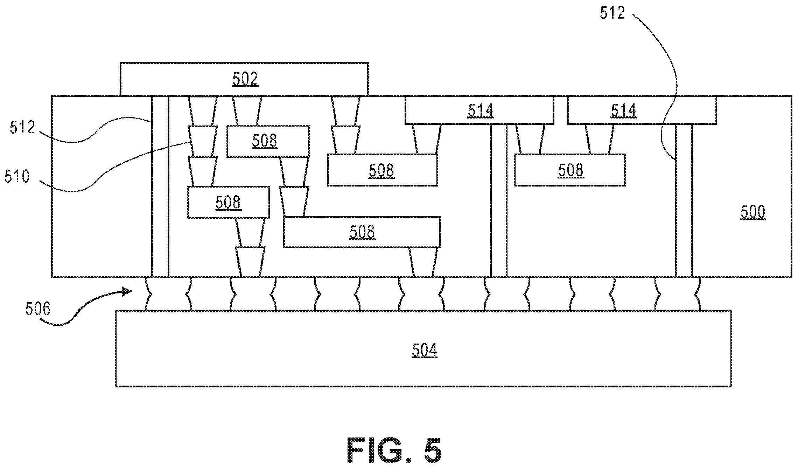

Figure 5 illustrates an interposer 500. The interposer 500 is an intervening substrate used to bridge a first substrate 502 to a second substrate 504. The first substrate 502 may be, for instance, an integrated circuit die. The second substrate 504 may be, for instance, a memory module, a computer motherboard, or another integrated circuit die. Generally, the purpose of an interposer 500 is to spread a connection to a wider pitch or to reroute a connection to a different connection. For example, an interposer 500 may couple an integrated circuit die to a ball grid array (BGA) 506 that can subsequently be coupled to the second substrate 504. In some embodiments, the first and second substrates 502/504 are attached to opposing sides of the interposer 500. In other embodiments, the first and second substrates 502/504 are attached to the same side of the interposer 500. And in further embodiments, three or more substrates are interconnected by way of the interposer 500.

The interposer 500 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 508 and vias 510, including but not limited to through-silicon vias (TSVs) 512. The interposer 500 may further include embedded devices 514, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 500. In accordance with embodiments of the invention, apparatuses or processes disclosed herein may be used in the fabrication of interposer 500.

Thus, embodiments of the present invention include aligned pitch-quartered patterning approaches for lithography edge placement error advanced rectification.

In an embodiment, a semiconductor structure includes a plurality of semiconductor fins protruding from a substantially planar surface of a semiconductor substrate. The plurality of semiconductor fins has a grating pattern interrupted by a first location having a first fin portion having a first height and interrupted by a second location having a second fin portion having a second height different from the first height. A trench isolation layer is disposed between the plurality of semiconductor fins and adjacent to lower portions of the plurality of semiconductor fins, but not adjacent to upper portions of the plurality of semiconductor fins. The trench isolation layer is disposed over the first and second fin portions. One or more gate electrode stacks is disposed on top surfaces and sidewalls of the upper portions of the plurality of semiconductor fins and on portions of the trench isolation layer. Source and drain regions are disposed on either side of the one or more gate electrode stacks.

In one embodiment, the grating pattern has a constant pitch.

In one embodiment, the source and drain regions are disposed adjacent to the upper portions of the plurality of semiconductor fins and are composed a semiconductor material different than the semiconductor material of the semiconductor fins.

In one embodiment, the source and drain regions are disposed within the upper portions of the plurality of semiconductor fins.

In one embodiment, the one or more gate electrode stacks include a high-k gate dielectric layer and a metal gate electrode.

In an embodiment, a semiconductor structure includes a plurality of semiconductor fins protruding from a substantially planar surface of a semiconductor substrate. The plurality of semiconductor fins has a grating pattern interrupted by a first location having a first recess below the substantially planar surface of the semiconductor substrate. A trench isolation layer is disposed between the plurality of semiconductor fins and adjacent to lower portions of the plurality of semiconductor fins, but not adjacent to upper portions of the plurality of semiconductor fins. The trench isolation layer is disposed in and over the first recess. One or more gate electrode stacks is disposed on top surfaces and sidewalls of the upper portions of the plurality of semiconductor fins and on portions of the trench isolation layer. Source and drain regions are disposed on either side of the one or more gate electrode stacks.

In one embodiment, the grating pattern is further interrupted by a second location having a second recess below the substantially planar surface of the semiconductor substrate, and the trench isolation layer is disposed in and over the second recess.

In one embodiment, the grating pattern is further interrupted by a second location having a fin portion above the substantially planar surface of the semiconductor substrate, and the trench isolation layer is disposed over the fin portions.

In one embodiment, the grating pattern has a constant pitch.

In one embodiment, the source and drain regions are disposed adjacent to the upper portions of the plurality of semiconductor fins and are composed of a semiconductor material different than the semiconductor material of the semiconductor fins.

In one embodiment, the source and drain regions are disposed within the upper portions of the plurality of semiconductor fins.

In one embodiment, the one or more gate electrode stacks includes a high-k gate dielectric layer and a metal gate electrode.

In an embodiment, a method of fabricating a semiconductor structure includes forming a first patterned hardmask on a semiconductor substrate, the first patterned hardmask having features spaced apart by a pitch. A second hardmask layer is formed on the semiconductor substrate, between the features of the first patterned hardmask. A segregated di-block co-polymer is formed on the first patterned hardmask and on the second hardmask layer, the segregated di-block co-polymer including alternating first and second polymer blocks having a pitch between first blocks approximately equal to half the pitch of the features of the first patterned hardmask. The second polymer blocks is removed from the segregated di-block co-polymer. Subsequent to removing the second polymer blocks, a second patterned hardmask is formed from the second hardmask layer and a plurality of semiconductor fins is formed in the semiconductor substrate using the first polymer blocks as a mask, the semiconductor fins having a pitch approximately equal to half the pitch of the features of the first patterned hardmask, wherein alternating fins of the plurality of semiconductor fins have corresponding alternating portions of the first patterned hardmask and the second patterned hardmask, respectively. A first fin of the plurality of semiconductor fins is removed, the first fin having a portion of the first patterned hardmask thereon. Subsequent to removing the first fin, a second fin of the plurality of semiconductor fins is removed, the second fin having a portion of the second patterned hardmask thereon.

In one embodiment, forming the second hardmask layer includes forming a blanket hardmask material over the semiconductor substrate and over the first patterned hardmask, and planarizing the blanket hardmask material.

In one embodiment, the method further includes, prior to forming the segregated di-block co-polymer, forming a first molecular brush layer selectively on the first patterned hardmask.

In one embodiment, the method further includes, prior to forming the segregated di-block co-polymer, forming a second molecular brush layer selectively on the second hardmask layer.

In one embodiment, forming the segregated di-block co-polymer includes forming a randomized di-block co-polymer on the first patterned hardmask and on the second hardmask layer, and then annealing the randomized di-block co-polymer.

In one embodiment, the method further includes, subsequent to forming the second patterned hardmask and forming the plurality of semiconductor fins and prior to removing the first and second fins, forming an inter-layer dielectric (ILD) layer over the plurality of semiconductor fins.

In one embodiment, the method further includes, subsequent to removing the first and second fins, recessing the ILD layer below a top surface of the plurality of semiconductor fins, exposing protruding portions of each of the plurality of semiconductor fins above sub-fin regions of each of the plurality of semiconductor fins.

In one embodiment, the method further includes forming one or more gate electrode stacks on the exposing protruding portions of each of the plurality of semiconductor fins.

In one embodiment, removing the first fin of the plurality of semiconductor fins includes etching the portion of the first patterned hardmask selective to exposed portions of the second patterned hardmask.
In one embodiment, removing the first fin of the plurality of semiconductor fins includes etching the portion of the second patterned hardmask selective to exposed portions of the first patterned hardmask.

## Claims

1. A method of fabricating a semiconductor structure, the method comprising:
forming a first patterned hardmask (104) on a semiconductor substrate (102), the first patterned hardmask (104) having features spaced apart by a pitch (106);
forming a second hardmask (108) layer on the semiconductor substrate (102), between the features of the first patterned hardmask (104);
forming a segregated di-block co-polymer (114, 116) on the first patterned hardmask (104) and on the second hardmask layer (108), the segregated di-block co-polymer comprising alternating first and second polymer blocks (114, 116) having a pitch (126) between first blocks (116) approximately equal to half the pitch (106) of the features of the first patterned hardmask (104);
removing the second polymer blocks (114) from the segregated di-block co-polymer;
subsequent to removing the second polymer blocks (114), forming a second patterned hardmask (124) from the second hardmask layer (108) and forming a plurality of semiconductor fins (118) in the semiconductor substrate (102) using the first polymer blocks (116) as a mask, the semiconductor fins (118) having a pitch (126) approximately equal to half the pitch (106) of the features of the first patterned hardmask (104), wherein alternating fins of the plurality of semiconductor fins (118) have corresponding alternating portions of the first patterned hardmask (104) and the second patterned hardmask (124), respectively;
removing a first fin of the plurality of semiconductor fins (118), the first fin having a portion of the first patterned hardmask (104) thereon; and
subsequent to removing the first fin, removing a second fin of the plurality of semiconductor fins (118), the second fin having a portion of the second patterned hardmask (124) thereon.

2. The method of claim 1, wherein forming the second hardmask layer (108) comprises forming a blanket hardmask material over the semiconductor substrate (102) and over the first patterned hardmask (104), and planarizing the blanket hardmask material.

3. The method of claim 1, further comprising:
prior to forming the segregated di-block co-polymer, forming a first molecular brush layer (110) selectively on the first patterned hardmask (104).

4. The method of claim 3, further comprising:
prior to forming the segregated di-block co-polymer, forming a second molecular brush layer selectively on the second hardmask layer (108).

5. The method of claim 1, wherein forming the segregated di-block co-polymer comprises forming a randomized di-block co-polymer on the first patterned hardmask (104) and on the second hardmask layer (108), and then annealing the randomized di-block co-polymer.

6. The method of claim 1, further comprising:
subsequent to forming the second patterned hardmask (124) and forming the plurality of semiconductor fins (118) and prior to removing the first and second fins, forming an inter-layer dielectric, ILD, layer (128) over the plurality of semiconductor fins (118).

7. The method of claim 6, further comprising:
subsequent to removing the first and second fins, recessing the ILD layer (128) below a top surface of the plurality of semiconductor fins (118), exposing protruding portions (172) of each of the plurality of semiconductor fins (118) above sub-fin regions (174) of each of the plurality of semiconductor fins.

8. The method of claim 7, further comprising:
forming one or more gate electrode stacks on the exposing protruding portions (172) of each of the plurality of semiconductor fins (118).

9. The method of claim 1, wherein removing the first fin of the plurality of semiconductor fins (118) comprises etching the portion of the first patterned hardmask (104) selective to exposed portions of the second patterned hardmask (124).

10. The method of claim 9, wherein removing the first fin of the plurality of semiconductor fins comprises etching the portion of the second patterned hardmask (124) selective to exposed portions of the first patterned hardmask (104).

## Patentansprüche

1. Verfahren zum Herstellen einer Halbleiterstruktur, das Verfahren umfassend:
Bilden einer ersten strukturierten Hardmaske (104) auf einem Halbleitersubstrat (102), wobei die erste strukturierte Hardmaske (104) durch ein Raster (106) beabstandete Merkmale aufweist;
Bilden einer zweiten Hardmasken-(108)-Schicht auf dem Halbleitersubstrat (102) zwischen den Merkmalen der ersten strukturierten Hardmaske (104);
Bilden eines abgesonderten Di-Block-Copolymers (114, 116) auf der ersten strukturierten Hardmaske (104) und auf der zweiten Hardmaskenschicht (108), wobei das abgesonderte Di-Block-Copolymer abwechselnde erste und zweite Polymerblöcke (114, 116) mit einem Raster (126) zwischen ersten Blöcken (116) ungefähr gleich der Hälfte des Rasters (106) der Merkmale der ersten strukturierten Hardmaske (104) umfasst;
Entfernen der zweiten Polymerblöcke (114) von dem abgesonderten Di-Block-Copolymer;
anschließend auf Entfernen der zweiten Polymerblöcke (114) Bilden einer zweiten strukturierten Hardmaske (124) aus der zweiten Hardmaskenschicht (108) und Bilden einer Vielzahl von Halbleiterrippen (118) in dem Halbleitersubstrat (102) unter Verwendung der ersten Polymerblöcke (116) als eine Maske, wobei die Halbleiterrippen (118) ein Raster (126) ungefähr gleich der Hälfte des Rasters (106) der ersten strukturierten Hardmaske (104) aufweisen, wobei abwechselnde Rippen der Vielzahl von Halbleiterrippen (118) korrespondierende abwechselnde Abschnitte der ersten strukturierten Hardmaske (104) bzw. der zweiten strukturierten Hardmaske (124) aufweisen;
Entfernen einer ersten Rippe der Vielzahl von Halbleiterrippen (118), wobei die erste Rippe einen Abschnitt der ersten strukturierten Hardmaske (104) darauf aufweist; und
anschließend auf Entfernen der ersten Rippe Entfernen einer zweiten Rippe der Vielzahl von Halbleiterrippen (118), wobei die zweite Rippe einen Abschnitt der zweiten strukturierten Hardmaske (124) darauf aufweist.

2. Verfahren nach Anspruch 1, wobei Bilden der zweiten Hardmaskenschicht (108) umfasst, ein Abdeckungshardmaskenmaterial über dem Halbleitersubstrat (102) und über der ersten strukturierten Hardmaske (104) zu bilden und das Abdeckungshardmaskenmaterial zu planarisieren.

3. Verfahren nach Anspruch 1, ferner umfassend:
vor dem Bilden des abgesonderten Di-Block-Copolymers Bilden einer ersten molekularen Bürstenschicht (110) selektiv auf der ersten strukturierten Hardmaske (104).

4. Verfahren nach Anspruch 3, ferner umfassend:
vor dem Bilden des abgesonderten Di-Block-Copolymers Bilden einer zweiten molekularen Bürstenschicht selektiv auf der zweiten Hardmaskenschicht (108).

5. Verfahren nach Anspruch 1, wobei Bilden des abgesonderten Di-Block-Copolymers umfasst, ein randomisiertes Di-Block-Copolymer auf der ersten strukturierten Hardmaske (104) und auf der zweiten Hardmaskenschicht (108) zu bilden und dann das randomisierte Di-Block-Copolymer zu tempern.

6. Verfahren nach Anspruch 1, ferner umfassend:
anschließend an Bilden der zweiten strukturierten Hardmaske (124) und Bilden der Vielzahl von Halbleiterrippen (118) und vor Entfernen der ersten und zweiten Rippen Bilden einer dielektrischen Zwischenschicht- bzw. ILD-Schicht (128) über der Vielzahl von Halbleiterrippen (118).

7. Verfahren nach Anspruch 6, ferner umfassend:
anschließend an Entfernen der ersten und zweiten Rippen Aussparen der ILD-Schicht (128) unter einer oberen Oberfläche der Vielzahl von Halbleiterrippen (118), Exponieren von hervorstehenden Abschnitten (172) jeder der Vielzahl von Halbleiterrippen (118) über Unterrippenregionen (174) jeder der Vielzahl von Halbleiterrippen.

8. Verfahren nach Anspruch 7, ferner umfassend:
Bilden eines oder mehrerer Gateelektrodenstapeln auf den exponierten Abschnitten (172) jeder der Vielzahl von Halbleiterrippen (118).

9. Verfahren nach Anspruch 1, wobei Entfernen der ersten Rippe der Vielzahl von Halbleiterrippen (118) umfasst, den Abschnitt der ersten strukturierten Hardmaske (104) selektiv zu exponierten Abschnitten der zweiten strukturierten Hardmaske (124) zu ätzen.

10. Verfahren nach Anspruch 9, wobei Entfernen der ersten Rippe der Vielzahl von Halbleiterrippen umfasst, den Abschnitt der zweiten strukturierten Hardmaske (124) selektiv zu exponierten Abschnitten der ersten strukturierten Hardmaske (104) zu ätzen.

## Revendications

1. Procédé de fabrication d'une structure semiconductrice, le procédé comprenant :
la formation d'un premier masque dur à motif (104) sur un substrat semi-conducteur (102), le premier masque dur à motif (104) ayant des caractéristiques espacées par un pas (106) ;
la formation d'une deuxième couche de masque dur (108) sur le substrat semi-conducteur (102), entre les caractéristiques du premier masque dur à motif (104) ;
la formation d'un copolymère à deux blocs séparés (114, 116) sur le premier masque dur à motif (104) et sur la deuxième couche de masque dur (108), le copolymère à deux blocs séparés comprenant des premier et deuxième blocs polymères alternés (114, 116) ayant un pas (126) entre des premiers blocs (116) approximativement égal à la moitié du pas (106) des caractéristiques du premier masque dur à motif (104) ;
le retrait des deuxièmes blocs polymères (114) du copolymère à deux blocs séparés ;
après le retrait des deuxièmes blocs polymères (114), la formation d'un deuxième masque dur à motif (124) à partir de la deuxième couche de masque dur (108) et la formation d'une pluralité d'ailerons semi-conducteurs (118) dans le substrat semi-conducteur (102) au moyen des premiers blocs polymères (116) servant de masque, les ailerons semi-conducteurs (118) ayant un pas (126) approximativement égal à la moitié du pas (106) des caractéristiques du premier masque dur à motif (104), des ailerons alternés de la pluralité d'ailerons semi-conducteurs (118) ayant des portions alternées correspondantes du premier masque dur à motif (104) et du deuxième masque dur à motif (124), respectivement ;
le retrait d'un premier aileron de la pluralité d'ailerons semi-conducteurs (118), le premier aileron ayant une portion du premier masque dur à motif (104) par-dessus ; et
après le retrait du premier aileron, le retrait d'un deuxième aileron de la pluralité d'ailerons semi-conducteurs (118), le deuxième aileron ayant une portion du deuxième masque dur à motif (124) par-dessus.

2. Procédé de la revendication 1, dans lequel la formation de la deuxième couche de masque dur (108) comprend la formation d'un matériau de masque dur de recouvrement par-dessus le substrat semi-conducteur (102) et par-dessus le premier masque dur à motif (104), et la planarisation du matériau de masque dur de recouvrement.

3. Procédé de la revendication 1, comprenant en outre :
avant la formation du copolymère à deux blocs séparés, la formation d'une première couche de brosse moléculaire (110), sélectivement sur le premier masque dur à motif (104).

4. Procédé de la revendication 3, comprenant en outre :
avant la formation du copolymère à deux blocs séparés, la formation d'une deuxième couche de brosse moléculaire, sélectivement sur la deuxième couche de masque dur (108).

5. Procédé de la revendication 1, dans lequel la formation du copolymère à deux blocs séparés comprend la formation d'un copolymère statistique à deux blocs sur le premier masque dur à motif (104) et sur la deuxième couche de masque dur (108), puis le recuit du copolymère statistique à deux blocs.

6. Procédé de la revendication 1, comprenant en outre :
après la formation du deuxième masque dur à motif (124) et la formation de la pluralité d'ailerons semi-conducteurs (118), et avant le retrait des premier et deuxième ailerons, la formation d'une couche diélectrique intercalaire, ILD (128) par-dessus la pluralité d'ailerons semi-conducteurs (118).

7. Procédé de la revendication 6, comprenant en outre :
après le retrait des premier et deuxième ailerons, le creusement de la couche ILD (128) sous une surface supérieure de la pluralité d'ailerons semi-conducteurs (118), l'exposition de portions en saillie (172) de chacun de la pluralité d'ailerons semi-conducteurs (118) au-dessus de sous-régions d'aileron (174) de chacun de la pluralité d'ailerons semi-conducteurs.

8. Procédé de la revendication 7, comprenant en outre :
la formation d'un ou plusieurs empilements d'électrode de grille sur les portions en saillie exposées (172) de chacun de la pluralité d'ailerons semi-conducteurs (118).

9. Procédé de la revendication 1, dans lequel le retrait du premier aileron de la pluralité d'ailerons semi-conducteurs (118) comprend la gravure sélective de la portion du premier masque dur à motif (104) jusqu'à des portions exposées du deuxième masque dur à motif (124) .

10. Procédé de la revendication 9, dans lequel le retrait du premier aileron de la pluralité d'ailerons semi-conducteurs comprend la gravure sélective de la portion du deuxième masque dur à motif (124) jusqu'à des portions exposées du premier masque dur à motif (104).
